# EUROPÄISCHE PATENTSCHRIFT

(11) **EP 1 217 742 B1**
(45) Veröffentlichungstag und Bekanntmachung des Hinweises auf die Patenterteilung: **04.08.2010**
(21) Anmeldenummer: 01129012.9
(22) Anmeldetag: 06.12.2001
(51) Int. Cl.: H03K 17/94, H03K 17/96

(54) **Elektronischer Schalter, insbesondere Lichtschalter**
Electronic switch, in particular optical switch
Commutateur électronique, en particulier commutateur optique

(30) Priorität: 19.12.2000 DE 10063305
(43) Veröffentlichungstag der Anmeldung: 26.06.2002
(73) Patentinhaber: EnOcean GmbH, 82041 Oberhaching (DE)
(72) Erfinder: Gerlach, Horst, Dr., 93073 Neutraubling (DE)
(74) Vertreter: Epping - Hermann - Fischer

(56) Entgegenhaltungen:
- DE-A1- 2 125 068
- DE-A1- 2 314 420
- DE-B1- 2 939 440
- DE-U1- 29 712 270

## Beschreibung

Die Erfindung bezieht sich auf einen elektronischen Schalter, insbesondere Lichtschalter, der mit Piezokeramik und Spannungsabgriff arbeitet. Ein bekannter Installationsschalter arbeitet in der Wirkungskette vom Bedienkörper her mit einem piezoelektrischen Wandler eines speziellen Sendelements, so dass beim Betätigen ein Sendevorgang ausgelöst wird. Das Sendeelement arbeitet nach der Oberflächenwellentechnik und kann und leitungslos schalten und Befehle an den Empfänger eines Schalters weiterleiten (DE-U-297 12 270).

Des Weiteren ist aus der Druckschrift DE 29 39 440 B1 eine Piezotaste in Form eines streifenförmigen piezoelektrischen Wandlers mit darauf angebrachter Elektrodenmetallisierung bekannt. Weiter umfasst der streifenförmige piezoelektrische Wandler einen Stützkörper aus Kunststoffmaterial. Dieser piezoelektrische Wandler wird durch Druckkräfte die auf den Wandler in seiner Längsrichtung wirken angeregt.

Der Erfindung liegt die Aufgabe zugrunde, einen elektronischen Schalter anzubieten, der auf einfachste Art und Weise ein sicheres Schalten eines entfernten Verbrauchers, zum Beispiel einer Lichtquelle, ermöglicht.

Die Lösung der geschilderten Aufgabe erfolgt nach der Erfindung durch einen Schalter nach Anspruch 1. Hierbei ist die Piezokeramik auf einen biegbaren elektrisch isolierenden Träger aufgebracht, der einen piezokeramischen Biegestreifen bildet. Der Spannungsabgriff ist mit einer Sendeeinrichtung verbunden. Der Biegestreifen kann das Bedienelement des Schalters direkt oder indirekt bilden. Die Sendestrahlung kann von einer Schalteinrichtung mit Empfänger empfangen werden.

Die Piezokeramik kann beiderseits auf dem Träger aufgebracht sein. Auf dem Träger können Bauelemente des Senders nach Art von Leiterplatten aufgebracht sein. Zwischen gegeneinander isolierter Piezokeramik kann Spannung abgegriffen werden. Derartige Elemente sind unter der Typenbezeichnung "Piezoelectric Ceramics Parallel Bimorph Elements", Bestellnummer 4322020-1453 bis -1462 der Firma Philips bekannt.

Die Erfindung soll nun anhand von in der Zeichnung grob schematisch wiedergegebenen Ausführungsbeispielen näher erläutert werden:
In FIG 1 sind mehrere piezokeramische Biegestreifen jeweils im Schnitt und mit einem Spannungsorgan verbunden veranschaulicht, die auch mit einer Sendeeinrichtung in Verbindung stehen.
In FIG 2 ist ein einzelner piezokeramischer Biegestreifen mit einem Taster als Bedienelement wiedergegeben, wobei der piezokeramische Biegestreifen im Schnitt veranschaulicht ist.

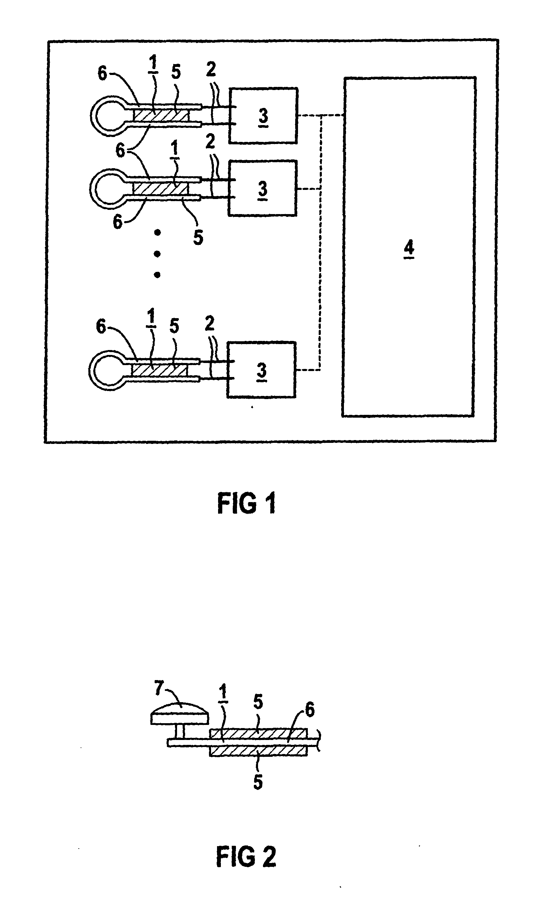

Der elektronische Schalter arbeitet mit piezokeramischen Biegestreifen 1, deren Spannungsabgriff 2 mit einem Spannungsorgan 3 jeweils in Verbindung steht. Im Ausführungsbeispiel arbeiten die Spannungsorgane auf einen Sender 4 nach FIG 1.

Die Piezokeramik 5 kann beiderseits auf einen Träger 6 aufgebracht sein. Auf dem Träger 6 können außer der Piezokeramik 5 nach Art von Leiterplatten weitere Bauelemente aufgebracht sein.

Im Ausführungsbeispiel nach FIG 1 ist der Träger ausgefräst, um eine Tasterzunge zu erzeugen, auf der die Piezokeramik 5 aufgebracht ist. Auf dem Träger können Leiterbahnen aufgebracht sein.

Im Ausführungsbeispiel nach FIG 2 ist der Träger 6 als Tasterzunge ausgebildet, die das Bedienelement eines Schalters indirekt bildet. Sie wird im Ausführungsbeispiel von einem Druckstößel 7 beaufschlagt. Im Ausführungsbeispiel nach FIG 2 ist die Piezokeramik 5 beiderseits des Trägers 6 aufgebracht. Der so gebildete piezokeramische Biegestreifen 1 kann wieder mit einem Sender zusammenarbeiten, der beispielsweise ein Infrarotfeld oder allgemein ein Feld nach Art von Funkwellen absendet. Je nach Ausführungsform können auch weitere Maßnahmen oder Mittel zur definierten Biegung des Biegestreifens 1 vorgesehen sein. Hierzu kann beispielsweise eine nicht näher gezeigte Stütze oder Unterlage dienen, die auf einem vorbestimmten Punkt dann Druck ausübt und über den eine Biegung erfolgt.

Beim elektronischen Schalter nach der Erfindung wird nicht mit Hochspannung im Kilovoltbereich gearbeitet, wie es bei Oberflächenwellenfiltern der Fall ist, sondern mit Kleinspannung in der Größenordnung von 5 V bis 50 V. Dies stellt an die Isolation erheblich geringere Anforderungen als beim Arbeiten mit herkömmlicher Piezokeramik, die auf Oberflächenwellenfilter arbeitet. Die üblicherweise nicht unproblematische Wandlung von Hoch- in Kleinspannung ist bei dieser Lösung nicht erforderlich.

## Patentansprüche

1. Elektronischer Schalter, insbesondere Lichtschalter, mit Piezokeramik (5) und Spannungsabgriff,
**dadurch gekennzeichnet, dass**
die Piezokeramik (5) auf einem biegbaren elektrisch isolierenden Träger (6) aufgebracht ist und einen piezokeramischen Biegestreifen (1) bildet, dessen Spannungsabgriff (2) mit einem Sender (4) in Verbindung steht.

2. Elektronischer Schalter nach Anspruch 1
**dadurch gekennzeichnet, dass**
die Piezokeramik (5) beiderseits auf dem Träger (6) aufgebracht ist.

3. Elektronischer Schalter nach Anspruch 1 oder 2
**dadurch gekennzeichnet, dass**
auf dem Träger (6) Bauelemente des Senders (4) aufgebracht sind.

4. Elektronischer Schalter nach Anspruch 3
**dadurch gekennzeichnet, dass**
der Träger (6) als Tasterzunge ausgebildet ist, die das Bedienelement des Schalters direkt oder indirekt bildet.

## Claims

1. An electronic switch, in particular a light switch, comprising a piezo-ceramic device (5) and a voltage tap,
**characterized in that**
the piezo-ceramic device (5) is applied on a bendable and electrically isolating carrier (6) and forms a piezo-ceramic bending strip (1) whose voltage tap (2) is in connection with a transmitter (4).

2. The electronic switch according to claim 1, **characterized in that**
the piezo-ceramic device (5) is applied on the carrier (6) on both sides.

3. The electronic switch according to claim 1 or 2, **characterized in that**
components of the transmitter (4) are applied on the carrier (6).

4. The electronic switch according to claim 3, **characterized in that**
the carrier (6) is configured as a push-button tongue which directly or indirectly forms the operating element of the switch.

## Revendications

1. Interrupteur électronique, en particulier interrupteur d'éclairage, comportant une piézocéramique (5) et une prise de tension,
**caractérisé en ce que**
la piézocéramique (5) est appliquée à un support flexible et électriquement isolant (6) et forme une lame flexible en piézocéramique, dont la prise de tension (2) est en communication avec un émetteur (4).

2. Interrupteur électronique selon la revendication 1, **caractérisé en ce que**
la piézocéramique (5) est appliquée de part et d'autre du support (6).

3. Interrupteur électronique selon la revendication 1 ou 2,
**caractérisé en ce que**
des composants de l'émetteur (4) sont appliqués au support (6).

4. Interrupteur électronique selon la revendication 3, **caractérisé en ce que**
le support (6) est réalisé comme languette de palpeur formant directement ou indirectement l'élément de commande de l'interrupteur.
